Europäisches Patentamt

European Patent Office

Office européen des brevets

(11) Publication number: **0 068 070**
A1

# EUROPEAN PATENT APPLICATION

(21) Application number: **82101438.8**

(22) Date of filing: **25.02.82**

(51) Int. Cl.³: **H 01 L 21/76, H 01 L 27/08**

(30) Priority: **01.07.81 US 279483**

(43) Date of publication of application: **05.01.83**
Bulletin 83/1

(84) Designated Contracting States: **DE FR GB**

(71) Applicant: **Rockwell International Corporation, 2230 East Imperial Highway, El Segundo, California 90245 (US)**

(72) Inventor: **Soclof, Sidney Isaac, 6419 N. Lemon, San Gabriel California 91775 (US)**

(74) Representative: **Wagner, Karl H., P.O. Box 246 Gewürzmühlstrasse 5, D-8000 Munich 22 (DE)**

(54) Complementary NPN and PNP lateral transistors separated from substrate by slots filled with substrate oxide for minimal interference therefrom and method for producing same.

(57) The invention is a pair of complementary NPN and PNP transistors or arrays thereof and method for producing same in sub-micron dimensions on a silicon substrate selectively doped P and N type by forming first sets of slots (4, 5) in spaced apart relation across the N substrate regions to define semi-arrays of intermediate regions which will become transistors. Silicon oxide fills these slots and separates the NPN transistor regions from the substrate. Orthogonal slots (8, 9) divide the semi-arrays into individual transistor active regions which are doped N+ with the doping introduced into each active region via the orthogonal slots and driven in to comprise the emitter and collector regions on respective sides of original substrate. The slots are deepened and P doping is introduced therein to replace the original substrate doping in the active regions, thereby comprising the base regions with the slots deepened into the original N substrate and oxide filled for total isolation. The same construction obtains in the P substrate regions, except first N doping via the slots (101, 102) changes the active regions from P to N, followed by P+ doping for the emitter and collector, slot deepening into the original P substrate and oxide filling for that isolation. Metallization patterns complete electrical connections to the emitter, base and collector regions and silicon oxide substantially covers the periphery of each active region for total isolation. Also, optionally, P+ doping may be introduced between the N+ emitter and collector adjacent the substrate surface,

and similarly, N+ doping between the N+ emitter and collector.

-1-

COMPLEMENTARY NPN AND PNP LATERAL
TRANSISTORS SEPARATED FROM SUBSTRATE BY
SLOTS FILLED WITH SUBSTRATE OXIDE
FOR MINIMAL INTERFERENCE THEREFROM AND
METHOD FOR PRODUCING SAME

### Field of the Invention

This invention is a novel structure and method for forming sub-micron type lateral dielectrically isolated complementary transistors utilizing VLSI chip processing steps to compatibly fabricate hundreds of such devices, simultaneously on a common functional chip.

### Background of the Invention

Techniques extracted from the prior art come from the field of sub-micron fabrication technology wherein the dimensional resolution is now comparable to or even smaller than the thicknesses of the thermally grown silicon oxide layers on silicon. Also, the dimensions are now comparable or even smaller than the base widths used for fused transistors, i.e., 0.4 to 1.0 micrometers. From these techniques, the novel structure and method for the complementary lateral transistors with greatly reduced parasitic capacitances and resistances are achieved.

### Summary of the Invention

The invention comprises novel lateral complementary transistors formed on a selectively N and P doped substrate by a first set of slots and a set of orthogonal slots relative thereto for respectively defining each active region. The slots are filled with substrate oxide to isolate the effective regions from the substrate. Prior to oxidation filling the orthogonal slots, selective doping is introduced from opposed surfaces of each individual NPN active region and the slots are deepened and doping opposite to the substrate doping is introduced via the deepened slots to change the substrate doping in the active regions to define the NPN formations. For the complementary PNP formations the substrate doping is reversed by opposite doping injected via the slots, followed by selective doping of opposed surfaces of each individual active region. The slots are deepened into the original substrate doped region and oxidation and electrode configurations are employed. The intersecting slots and the orthogonal slots of the complementary devices are preferably respectively orthogonally related. Electrical connections are made in conventional fashion to become emitter, base and collector regions.

Brief Description of the Drawings

FIG. 1 shows a portion of a chip including separate formations of NPN and PNP devices;

FIG. 2 is a view in cross-section through a region of the substrate doped N where a single NPN transistor will be formed showing photoresist outlining the regions to be recessed into the substrate and also protecting the active region of the transistor;

FIG. 3 shows the substrate slotted along the boundary recess regions with N+ doping having been achieved followed by oxide growth;

FIG. 4 shows the boundary recesses deepened beyond the N+ doped regions;

FIG. 5 shows the P region formed by diffusion through the slots and also between the N+ regions;

FIG. 6 shows the recessed regions extending into the N doped substrate, beyond the P doped regions and the boundary recesses filled with oxide;

FIG. 7 shows the P+ implanting of the non N+ doped active region adjacent and the results of the patterning and metallization steps;

FIG. 8 is a plan view of a single lateral NPN transistor showing the boundary recesses filled with field oxide and the emitter, base and collector electrode with electrical connections included.

FIG. 9 is a view in cross-section through a region of the substrate where a single PNP transistor will be formed showing photoresist outlining the regions to be recessed into the substrate and also protecting the active region of the transistor;

FIG. 10 shows the substrate slotted along the boundary recess regions with N doping having been achieved via the slots to change the doping of the substrate in the active regions followed by oxide growth;

FIG. 11 shows the P+ doped regions;

FIG. 12 shows the slots extended beneath the P+ regions;

FIG. 13 shows the recessed regions extending into the P doped substrate, beyond the P+ doped regions and the boundary recesses filled with oxide;

FIG. 14 shows the N+ implanting of the upper substrate doped active region and the results of the patterning and metallization steps; and

FIG. 15 is a plan view of a single lateral PNP transistor showing boundary recess(es) filled with field oxide and the emitter, base and collector electrodes with electrical connections included.

Brief Description of a Preferred Embodiment of the Invention

In the devices produced in accordance with the present invention, the effects of the substrate are minimized relative to the operation of the devices. It should be realized that the isolated active region may be completely contained within a surface area of approximately $5d \times 3d = 15d^2$ wherein d is only 0.4 micrometers. Each active region is completely separated from the substrate by substrate oxidation and the parasitic capacitances and resistances are almost completely reduced to a minimum value attainable because the transistors are reduced to just their electronically active regions. In the conventional (vertical) transistor, the electrically active region is only a very small fraction of the total transistor area or volume. The dielectric isolation between transistors offered by the substrate oxidation has advantages with respect to high frequency performance, high voltage integrated circuits, radiation resistance, and circuit flexibility, i.e., the process provides NPN and PNP devices on the same integrated circuit chip.

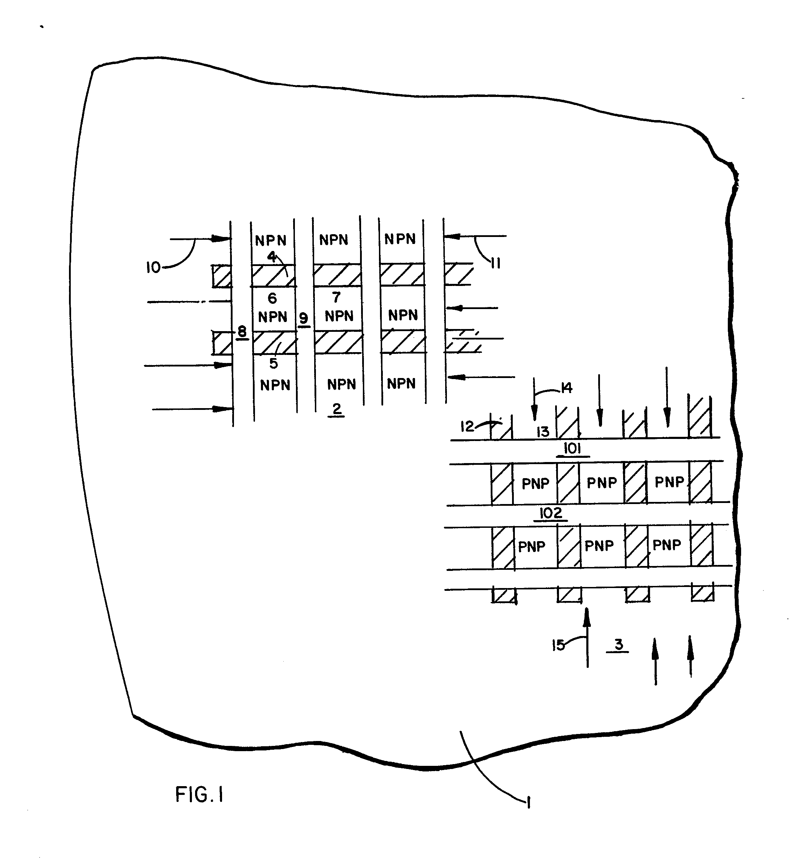

In FIG. 1, the chip or die is partly shown at 1 carrying a NPN formation of transistor structures 2 and a separate PNP formation of transistor structures 3.

In formation 2, a pair of intersecting slots 4 and 5 form active regions 6 and 7 separated by orthogonal slots 8 and 9. The arrows 10 and 11 illustrate the angle doping paths (when tilted upwardly) for N or N+ doping of the underlying substrate. Subsequently, slots 8 and 9 are also filled with oxide and electrical connections are established to the electrode regions of the isolated active transistor regions.

In formation 3, the intersecting slots 12 and 13 of the P region are illustrated orthogonal to intersecting slots 4 and 5 of the N region 2, and the directions of angled doping, shown by arrows 14 and 15, is at right angles to arrows 10 and 11 of region 2. Since ion milling and ion doping are preferably employed, many regions, such as 2 and 3, may be selectively distributed across the chip 1, and accurately indexed by present day conventional techniques. This offers versatility of association of the complementary transistors. Use of the illustrated orthogonal relationship of slots 8 and 9 to slots 101 and 102 serves to prevent contaminating of doping (i.e.) N type doping is only injected at right angles to P type doping.

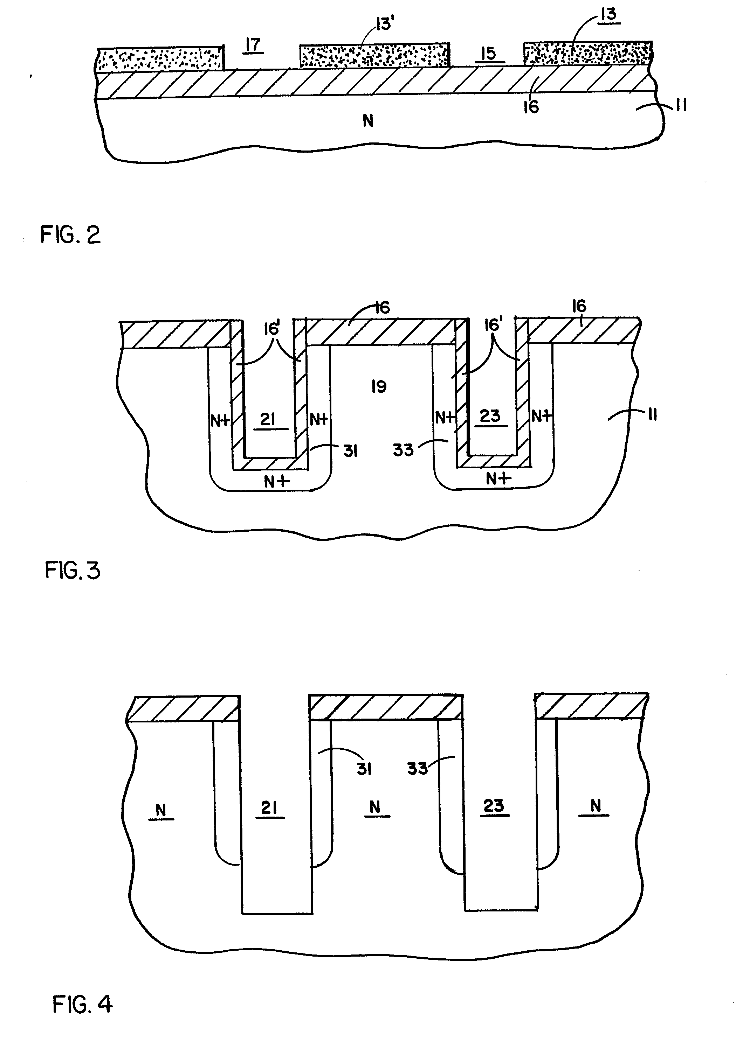

In FIG. 2, the N type substrate 11 may comprise silicon or silicon-on-sapphire. It is covered with a photoresist layer 13 which is masked, exposed to actinic radiation, and the photoresist layer 13 which is masked, exposed to actinic radiation, and the photoresist removed where soluble in the regions 15 and 17 which outlines the portions of the substrate to be slotted or recessed around the boundary of the active region 19 (FIG. 3) for a single transistor, shown as that region covered by the photoresist 13'.

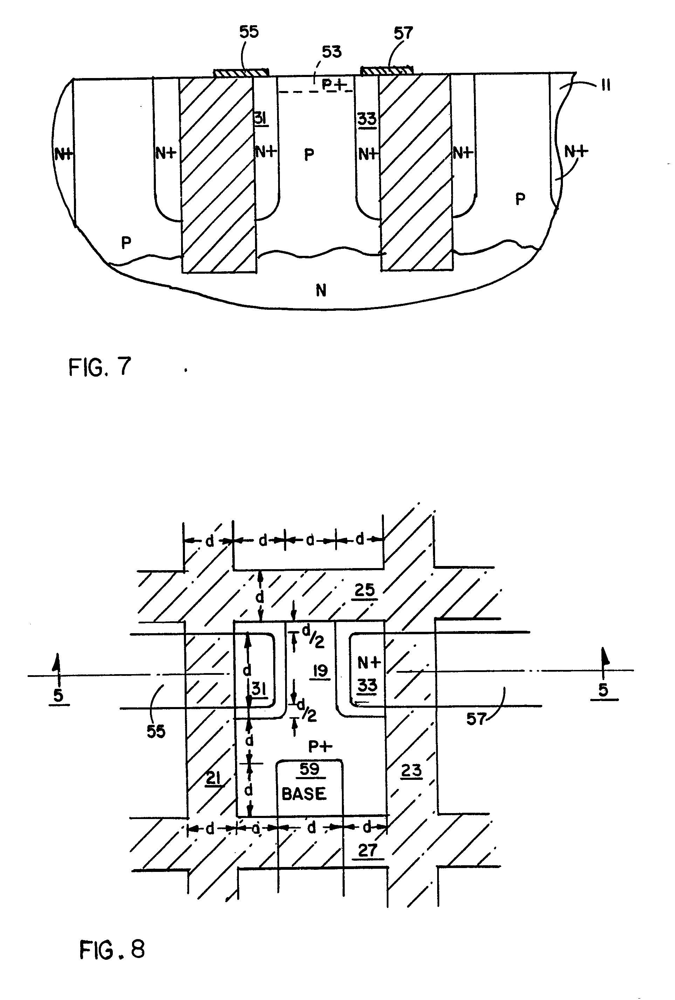

In FIG. 3 the slots 21 and 23 have been milled into substrate 11 in the regions 17 and 15 while the other regions were protected by the photoresist 13. It will be understood that slots or recesses 21 and 23, as shown in FIG. 2, only bound the active region 19 on two sides, but in reality this boundary recessing or slotting extends completely about the transistor active region 19 as illustrated in FIG. 8 wherein the slots portions 21 and 23 are seen as bounding two sides of region 19 whereas slots 25 and 27 bound the other two regions such that the entire active area 19 is bounded by recesses or slots.

Returning to FIG. 3, the next step in the preferred process is the deposition of arsenic into slots 21 and 23 to form the N+ doped regions 31 and 33 adjacent to the slots 21 and 23 within substrate 11.

Following the N+ doping step, silicon oxide is grown over the entire exposed surface of substrate 11, as shown at 16 and 16'.

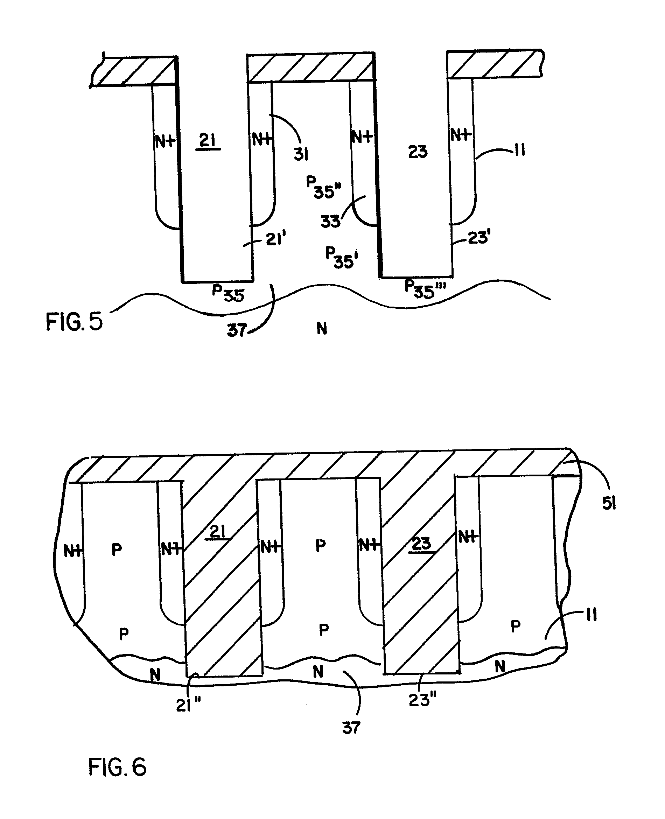

Proceeding to FIG. 4, the slots 21 and 23 are milled deeper, as shown by the extensions 21' and 23' which penetrate substrate 11 deeper than the N+ doped regions 31 and 33. Also, the silicon oxide lining slots 21 and 23, as deepened, is removed following conventional practices to prepare for the boron diffusion step best depicted in FIG. 5. Here the P type regions are indicated at 35, 35', 35'' and 35'''. The N type region of substrate 11 is now roughly defined by the line 37. It will be seen that the P region is beneath the slot 21 extension 21' and the slot extension 23', and also occupies the region between the N+ active portions 31 and 33.

In FIG. 6, the third deepening of slots 21 and 23 is effected, again preferably by ion milling, to extend them to their bottoms 21'' and 23'' which now penetrates the N region beneath curve 37. The substrate 11 is then oxidized sufficiently to fill the slots 21 and 23 completely with silicon oxide and to cover the substrate 11 with a surface layer 51 of silicon oxide. At this stage it may be noted that the silicon oxide of the recesses or slots completely electrically isolates the N+PN+ active region of the transistor device being formed in the active region within this isolation boundary.

In FIG. 7, the oxide has been stripped completely off the top, shown as the oxide 51, as by etching, to allow for the boron B+ implant indicated by the P+ designation at 53. One way of achieving this type doping is to use low energy boron diffusion for the P regions and high energy boron diffusion for the P+ regions.

Also in FIG. 7, a layer of metallization has been applied to the upper surface of the substrate 11, and it has been covered by photoresist and patterned, removed where soluble and the metallization etched away to leave the particular metal conductors 55 and 57 shown in contact with the N+ region 31 and the N+ region 33. In the same manner the base lead 59 (FIG. 8) has been formed from the metallization and patterning steps, as shown in FIG. 7 such that electrode connections are made to emitter region 31, collector region 33 and base region 59.

It will be noted from FIG. 8 that the sectional view for FIG. 7 is taken along the plane 5-5. Also, the transistor of FIG. 8 is sized 4d x 5d to occupy an area of $20d^2$, wherein d is a dimension of 0.4 to 1 micrometer. It may be seen that the vertical dimension comprises the first d for the base region 59, the second d for the spacing between the base region and the emitter region 31, the third d for the width of the emitter region 31 and $\frac{d}{2} + \frac{d}{2}$ for the spacing between electrode 55 and the extremes of the N+ region 31 with the fifth d encompassing one recess 25. The dimension in the orthogonal direction utilizes the first d for the width of the recess 21, the second d for the spacing to the electrode 59, the third d for the width of the base electrode 59 and the fourth d measures to recess 23. In summary, these bipolar transistors have extremely small areas and the parasitic capacitance and resistance is also greatly reduced. The total size of the transistor is not much greater than the active area of the transistor. The base emitter junction capacitance and the collector base capacitance are made very small. Also, the base spreading resistance is small. Since the base width can be made small, i.e., approaching approximately 0.1 micrometers, a high gain and low transit time can be achieved. Also, a symmetrical transistor with a very low collector to emitter saturation voltage is available. Further, the collector resistance is also very small.

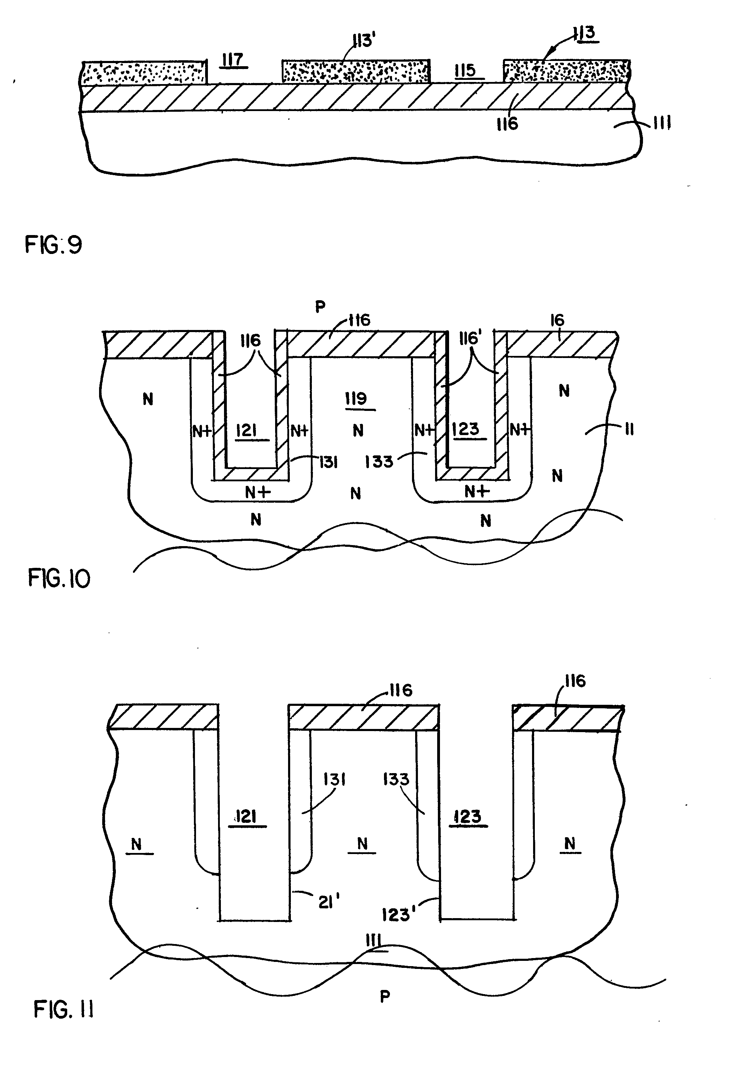

In FIG. 9, the P type substrate 111 may comprise silicon or silicon-on-sapphire. The substrate 111 is first optionally oxidized, as shown at 116. It is then covered with a photoresist layer 113 which is masked, exposed to actinic radiation, and the photoresist removed where soluble in the regions 115 and 117 which outlines the portions of the substrate to be slotted or recessed around the boundary of the active region 119 (FIG. 10) for a single transistor, shown as that region covered by the photoresist 113'.

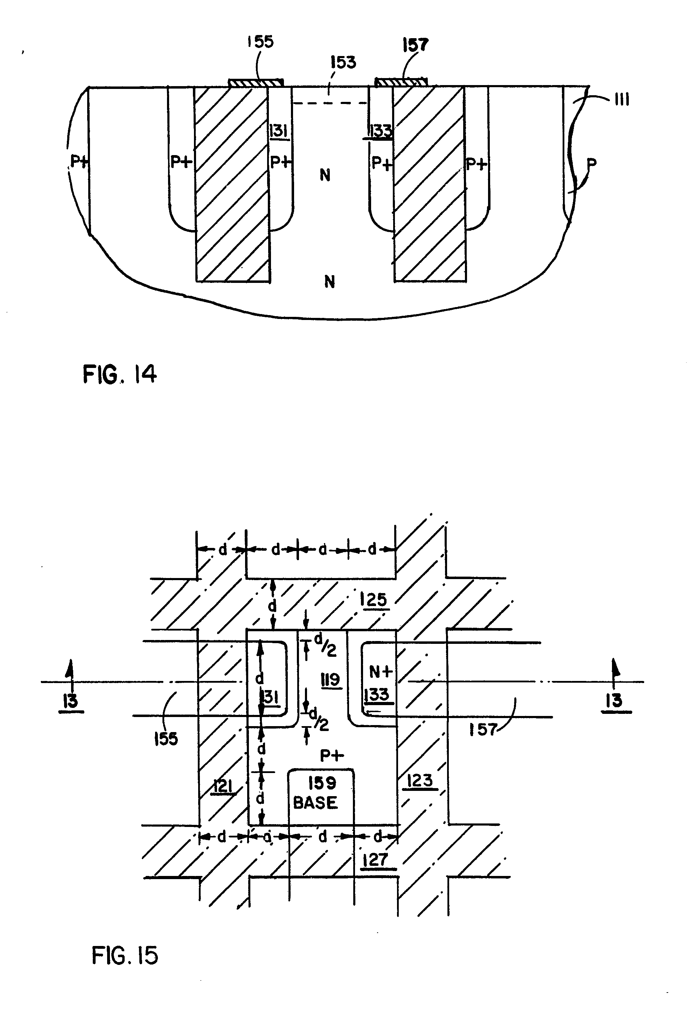

In FIG. 10, the slots 121 and 123 have been milled into substrate 111 in the regions 117 and 115 while the other regions were protected by the photoresist 113 and optional oxide. It will be understood that slots or recesses 121 and 123, as shown in FIG. 10, only bound the active region 119 on two sides, but in reality this boundary recessing or slotting extends completely about the transistor active region 119, as illustrated in FIG. 15 wherein the slot portions 121 and 123 are seen as bounding two sides of region 119, whereas slots 125 and 127 bound the other two sides, such that the entire active area 119 is bounded by recesses or slots (i.e.) a peripheral recess.

Returning to FIG. 10, the next step in the preferred process is the deposition of arsenic or phosphorous into slots 121 and 123 to change the doping of the substrate from P to N in the active regions.

Following the N doping step, silicon oxide is grown over the entire exposed surface of substrate 111, as shown at 116 and 116'. If oxide layer 116 was originally employed (as in FIG. 9) it is merely thickened in this step. Then boron is diffused into the substrate and P+ regions 131 and 133.

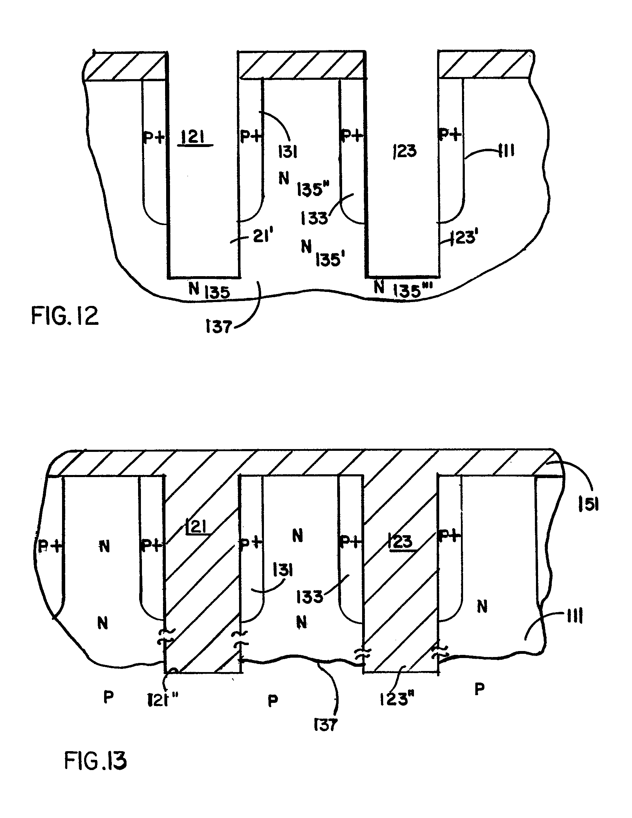

Proceeding to FIG. 11, the slots 121 and 123 are milled deeper, as shown by the extensions 121' and 123' which penetrate substrate 111 deeper than the P+ doped regions 131 and 133. Also, any remaining silicon oxide lining slots 121 and 123, as deepened, is removed following conventional practices. In FIG. 12, the N type regions are indicated as 135, 135', 135'' and 135'''. The N to P region of substrate 111 is now roughly defined by the line 137. It will be seen that the N region is beneath the slots 121 extension 121' and the slot extension 123, extension 123', and also occupies the region between the P+ active portions 131 and 133.

In FIG. 13, the next deepening of slots 121 and 123 is effected, again preferably by ion milling, to extend them to their bottoms 121'' and 123'' which now penetrate the P substrate region beneath curve 137. The substrate 111 is then oxidized sufficiently to fill the slots 121 and 123 completely with silicon oxide and to cover the substrate 111 with a surface layer 151 of silicon oxide. At this stage, it may be noted that the silicon oxide of the recesser or slots completely electrically isolates the P+NP+ active region of the transistor device being formed in the active region within this isolation boundary.

In FIG. 14, the oxide has been stripped completely off the top, (shown as the oxide 151), as by etching, to allow for the optional arsenic N+ implant, indicated by the N+ designation at 153. One way of achieving this type doping is to use low energy arsenic diffusion for the N regions and high energy arsenic diffusing for the N+ regions.

Also, in FIG. 14, a layer of metallization has been applied to the upper surface of the substrate 111, and it has been covered by photoresist and patterned, removed where soluble, and the metallization etched away to leave the particular metal conductors 155 and 157 shown in contact with the P+ region 131 and the P+ region 133. In the same manner the base lead 159 (FIG. 15) has been formed from the metallization and patterning steps, as shown in FIG. 14 such that electrode connections are made to emitter region 131, collector region 133 and base region 159.

It will be noted from FIG. 15 that the sectional view for FIG. 14 is taken along the plane 5-5. Also, the transistor of FIG. 15 is sized $4\ 5d$ to occupy an area of $20d^2$, wherein d is a dimension of 0.4 to 1 micrometer. It may be seen that the vertical dimension comprises the first d for the base region 159, the second d for the spacing between the base region and the emitter region 131, the third d for the width of the emitter region 131 and $\frac{d}{2} + \frac{d}{2}$ for the spacing between electrode 155 and the extremes of the N+ region 131 with the fifth d encompassing one recess 125. The dimension in the orthogonal direction utilizes the first d for the width of the recess 121, the second d for the spacing to the electrode 159, the third d for the width of the base electrode 159 and the fourth d measures to recess 123. In summary, these bipolar transistors have extremely small areas and the parasitic capacitance and resistance is also greatly reduced. The total size of the transistor is not much greater than the active area of the transistor. The base emitter junction capacitance and the collector base capacitance are made very small. Also, the base spreading resistance is small. Since the base width can be made small, i.e., approaching approximately 0.1 micrometers, a high gain and low transit time can be achieved. Also, a symmetrical transistor with a very low collector to emitter saturation voltage is available. Further, the collector resistance is also very small.

It should be mentioned that the N and P formations need not be at right angles but this arrangement insures that ion doping is carried out most efficiently and there are no components of doping intended for NPN transistors which dope the complementary PNP transistors. This orientation facilitates higher speed and more efficient processing.

The dielectrically isolated complementary transistors of this invention have no junction curvature and thus exhibit higher breakdown voltages. Also, they exhibit very low capacitances, i.e., $C_{cb}$, $C_{be}$, and $C_{cs}$. Similarly, bulk resistance is very low (i.e.) $r_{bb}$, $r_{cc}'$ and $r_{ee}'$. Symmetrical transistors are readily available with very low $V_{CE}$ at $I_c = 0$. Also available is high $\beta$ at low current levels ( $\geq 1nA$ with no current crowding at the higher current levels. By the use of oversize geometry, close control over transistor parameters is possible with respect to the absolute values, and more importantly, the matching tolerances, partly due to the excellent control available with respect to base width since it is now a function of lateral geometry and not of the small differences of two diffusions as in conventional double diffused transistors.

Other modifications may occur to those skilled in the art, such as driving in the doping for the collector and emitter regions. Forming electrodes from constructions other than metallization layers, etc., and such modifications may be incorporated into the unique structures and methods herein disclosed.

WHAT IS CLAIMED IS:

1. An array of sub-micron dimensioned complementary NPN and PNP type lateral transistors formed on a silicon substrate doped P and N type, comprising in combination:

a plurality of first sidewalls of pairs of slots in spaced apart relation across the P and N regions of the substrate defining semi-arrays of intermediate regions which will become transistors;

silicon oxide filling said slots and covering the surface of the substrate through which they were made;

a plurality of second sidewalls of orthogonal slots relative to said pairs of slots dividing the semi-arrays of regions into individual transistor active regions;

N doping introduced into said active regions in the N substrate region via said second sidewalls and driven in to comprise N+ emitter and collector region on respective sides of the original N substrate;

N doping introduced into the substrate via the orthogonal slot sidewalls and bottoms of the P doped substrate region to change the doping of the substrate in the active regions from P to N;

said second sidewalls of the original N regions being deepened and P doping opposite to the local substrate region N doping being introduced to change the substrate doping in the active regions other than the emitter and collector regions so it becomes the respective N base regions;

P doping introduced into the non-N doped original P region via the orthogonal sidewalls to comprise emitter and collector regions for the PNP transistors being formed;

the orthogonal slots in the original N region being deepened into the original N substrate and the orthogonal slots in the original P region being deepened into the original P substrate;

oxidation filling the orthogonal slots;

Claim 1 continued

metallization patterns in electrical connection with the respective emitter, base and collector regions; and,

silicon oxide at least substantially covering the periphery of each active region.

2. Transistor arrays in accordance with claim 1, wherein: said first mentioned slots for the NPN transistors, are normal to said first mentioned slots for the PNP transistors; and, said orthogonal slots for the NPN transistors are normal to said orthogonal slots for the PNP transistors.

3. The transistor arrays in accordance with claims 1 and 2, further comprising P+ doping for the substrate surface regions between the N+ emitters and collectors and N+ doping for the substrate surface regions between the P+ emitters and collectors.

4. A pair of NPN PNP complementary transistors formed on a common substrate, comprising in combination:

a P doped portion of said substrate;

a pair of parallel slots in said portion filled with substrate oxide defining the length of the PNP transistor;

an orthogonal pair of slots in said P portion relative to said parallel slots through which N doping is introduced into the active region of said PNP transistor to comprise the base therefor; P+ doping thereafter comprising the emitter and collector; and said slots being deepened into the original P substrate for isolation;

said orthogonal slots filled with substrate oxide;

an N doped portion of said substrate;

a second pair of parallel slots in said N portion filled with substrate oxide defining the length of the NPN transistor;

a second pair of orthogonal slots in said N portion relative to said second pair of parallel slots through which N+ doping is driven into the ends of said NPN transistor to comprise the collector and emitter respectively, said base being comprised of N doped substrate changed to P doping by deepening the second pair of orthogonal slots and introducing the P doping;

said second pair of orthogonal slots filled with substrate oxide; and,

conductors in electrical connection with at least said emitters, bases, and collectors.

5. A method of forming complementary transistors each having an active region formed on a common substrate, comprising the steps of:

doping regions of the substrate P and other regions N;

recessing the substrate substantially along the periphery of each transistor active region;

selectively doping the transistor active regions through portions of the recesses formed by said recessing;

deepening said portions of the recesses and introducing doping opposite to the local substrate to change it;

filling said recesses with substrate oxide to isolate the active regions from said substrate; and,

forming conductors to different portions of each active region to serve as electrode connections.

6. The complementary transistors of claim 5, wherein:

said selective doping is P+ for P regions of the substrate and N+ for N regions of the substrate.

7. The complementary transistors of claim 6, wherein:

NPN transistors are formed in N regions of the substrate and PNP transistors are formed in P regions of the substrate.

117

FIG.1

FIG. 2

FIG. 3

FIG. 4

FIG.5

FIG.6

FIG. 7

FIG. 8

FIG. 9

FIG. 10

FIG. 11

FIG. 12

FIG. 13

FIG. 14

FIG. 15

# EUROPEAN SEARCH REPORT

**European Patent Office**

Application number

EP 82 10 1438.8

## DOCUMENTS CONSIDERED TO BE RELEVANT

| Category | Citation of document with indication, where appropriate, of relevant passages | Relevant to claim |
|---|---|---|
| A | EP - A1 - 0 004 298 (WESTERN ELECTRIC CO.) <br> * page 5, line 11 to page 8, line 1 * | 1 |
| A | Patent Abstracts of Japan <br> Vol. 1, No. 49, 13 May 1977 <br> page 3167E76 <br> & JP - A - 51 - 145276 | 1,5 |
| A | DE - A1 - 2 529 951 (SIEMENS) <br> * page 3, first paragraph * | 3 |
| A | US - A - 4 214 315 (N.G. ANANTHA et al.) <br> * column 6, line 17 to column 7, line 40 * | |

**CLASSIFICATION OF THE APPLICATION (Int. Cl. 3)**

H 01 L 21/76
H 01 L 27/08

**TECHNICAL FIELDS SEARCHED (Int.Cl. 3)**

H 01 L 21/263
H 01 L 21/308
H 01 L 21/76
H 01 L 27/08
H 01 L 29/06
H 01 L 29/72

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| Berlin | 17-09-1982 | GIBBS |

EPO Form 1503.1 06.78